(19) Europäisches Patentamt
European Patent Office
Office européen des brevets

(11) **EP 4 580 092 A1**

(12) **EUROPEAN PATENT APPLICATION**

(43) Date of publication:
**02.07.2025 Bulletin 2025/27**

(21) Application number: **24221176.1**

(22) Date of filing: **18.12.2024**

(51) International Patent Classification (IPC):
**H04B 17/13** (2015.01)     **H04B 17/16** (2015.01)
**H04B 17/19** (2015.01)

(52) Cooperative Patent Classification (CPC):
**H04B 17/16; H04B 17/13; H04B 17/19;**
H04B 17/103; H04B 17/104; H04B 17/17;
H04B 17/18

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **29.12.2023 US 202318400862**

(71) Applicant: **Analog Devices International
Unlimited Company
Limerick (IE)**

(72) Inventors:
- **KHALIL, Ahmed Ibrahim**
  **Co. Limerick (IE)**
- **ESMAEL, Mohamed Moussa Ramadan**
  **Co. Limerick (IE)**

(74) Representative: **Wallin, Nicholas James
Withers & Rogers LLP
2 London Bridge
London SE1 9RA (GB)**

(54) **POWER AMPLIFIER SYSTEM WITH INTERFERENCE CANCELLATION**

(57)     Aspects of this disclosure relate to a cancelling interference at an output of a power amplifier. An interference sensing circuit in a signal path between the power amplifier and an antenna can generate an interfering power signal. An interference cancellation loop can receive the interfering power signal and provide a cancellation signal to a transmit signal path that includes the power amplifier to thereby suppress interference at the output of the power amplifier. In certain embodiments, the interference cancellation loop includes an amplifier and a phase shifter. Related systems and methods are disclosed.

FIG. 3

# EP 4 580 092 A1

**Description**

BACKGROUND

TECHNICAL FIELD

The disclosed technology relates to radio frequency systems and power amplifiers. Embodiments of this disclosure relate to reducing interference in systems that include power amplifiers.

DESCRIPTION OF RELATED TECHNOLOGY

Radio systems can transmit and receive signals in the form of electromagnetic waves having a frequency in range from approximately 30 kilohertz (kHz) to 300 Gigahertz (GHz). Radio systems can be used for wireless communications, such as cellular communications and/or other wireless network communications.

Radio systems that transmit signals often include a power amplifier to amplify a radio frequency signal for transmission via one or more antennas. In some such systems, a plurality of power amplifiers can drive antennas of an antenna array. There can be challenges related to meeting technical specifications in such systems related to driving the antennas with independent streams concurrently.

SUMMARY OF CERTAIN INVENTIVE ASPECTS

The innovations described in the claims each have several aspects, no single one of which is solely responsible for its desirable attributes. Without limiting the scope of the claims, some prominent features of this disclosure will now be briefly described.

One aspect of this disclosure is a power amplifier system with interference cancellation. The power amplifier system includes a transmit signal path, an interference sensing circuit, and an interference cancellation loop. The transmit signal path includes a power amplifier. The interference sensing circuit is connected to an output of the power amplifier. The interference sensing circuit is configured to output an interfering power signal. The interference cancellation loop includes an amplifier. The interference cancellation loop is configured to receive the interfering power signal and to provide a cancellation signal to the transmit signal path to thereby suppress interference at the output of the power amplifier.

The interference cancellation loop can further include a phase shifter. The interference cancellation loop can be configured to generate the cancellation signal by at least amplifying and phase shifting the interfering power signal using the amplifier and the phase shifter. The phase shifter is connected to the interference sensing circuit by way of the amplifier in some instances. The interference cancellation loop can have a controllable gain, and the interference cancellation loop can set the controllable gain to control the amplitude of the cancellation signal.

The interference sensing circuit can include a radio frequency coupler. The radio frequency coupler can be configurable into a first state and a second state. The radio frequency coupler can be configured to couple interfering power in the first state. The radio frequency coupler can be configured to couple forward power in the second state.

The power amplifier system can further include an antenna array. The antenna array can include a first antenna that is connected to the power amplifier by way of the interference sensing circuit. The interference can include interference associated with coupling of a second antenna of the antenna array and the first antenna. The interference can include reflected power associated with the first antenna. In some instances, the power amplifier system does not include an antenna array and the interference can be generated due to an impedance mismatch at the output of the power amplifier.

The power amplifier system can further include an interfering power monitoring circuit configured to enable the interference cancellation loop based on a power level of the interfering power signal.

The interference cancellation loop can be configured to apply the cancellation signal to at an output side of the power amplifier.

The interference cancellation loop can be configured to apply the cancellation signal to an input side of the power amplifier. The power amplifier system can further include a non-linearity cancellation loop configured to provide a non-linearity cancellation signal at the input side of the power amplifier.

The power amplifier system can further include a radio frequency coupler and a digital predistortion circuit, where the second radio frequency coupler is configured to provide a coupled power signal to the digital predistortion circuit. The coupled power signal can be associated with power propagating from the output of the power amplifier to an antenna. The digital predistortion circuit can be configured to reduce non-linearity of the power amplifier output.

Another aspect of this disclosure is a power amplifier system with interference cancellation. The power amplifier system includes an array of antennas, a transmit signal path that includes a power amplifier, a radio frequency coupler, and an interference cancellation loop. The antenna array includes a first antenna and a second antenna. The power amplifier is configured to drive the first antenna. The radio frequency coupler is in a signal path between the power amplifier and the first antenna. The radio frequency coupler is configured to generate an interfering power signal. The interference cancellation loop includes an amplifier and a phase shifter. The interference cancellation loop is configured to receive the interfering power signal and to provide a cancellation signal to the transmit signal path to suppress interference at an output of the power amplifier. The interference includes an aggressor signal associated with the second antenna.

The power amplifier system can further include an interfering power monitoring circuit configured to enable the interference cancellation loop based on a power level of the interfering power signal.

The interference cancellation loop can be configured to apply the cancellation signal at an output side of the power amplifier.

Another aspect of this disclosure is a method of interference cancellation in a power amplifier system. The method includes sensing interference in a signal path between a power amplifier and a first antenna, generating a cancellation signal based on the sensing, and applying the cancellation signal to a transmit signal path that includes the power amplifier to suppress the interference at the output of the power amplifier. The interference propagates in a direction toward an output of the power amplifier. The interference includes an aggressor signal associated with a second antenna.

Sensing interference can include generating a coupled power signal using a radio frequency coupler. Generating the cancellation signal can include amplifying and phase shifting the coupled power signal. The method can further include enabling circuitry that generates the cancellation signal based on a power level of the coupled power signal.

Applying the cancellation signal can include applying the cancellation signal at an output side of the power amplifier.

For purposes of summarizing the disclosure, certain aspects, advantages and novel features of the innovations have been described herein. It is to be understood that not necessarily all such advantages may be achieved in accordance with any particular embodiment. Thus, the innovations may be embodied or carried out in a manner that achieves or optimizes one advantage or group of advantages as taught herein without necessarily achieving other advantages as may be taught or suggested herein.

BRIEF DESCRIPTION OF THE DRAWINGS

Embodiments of this disclosure will be described, by way of non-limiting example, with reference to the accompanying drawings.

Figure 1 is a schematic diagram of a radio frequency system with an antenna array and signal streams according to an embodiment.

Figure 2 is a graph illustrating an intermodulation generated by mixing between a main stream and an aggressor stream.

Figure 3 is a schematic diagram of a power amplifier system with interference cancellation according to an embodiment.

Figure 4A is a schematic diagram of an example of the power amplifier system of Figure 3 according to an embodiment.

Figure 4B is a schematic diagram of a power amplifier system with configurable radio frequency coupler according to an embodiment.

Figure 4C is a schematic diagram of a power amplifier system with interference cancellation for multiple power amplifier stages according to an embodiment.

Figure 5 is a schematic diagram of a power amplifier system with interference power monitoring and interference cancellation according to an embodiment.

Figure 6 is a graph showing output power over frequency for a power amplifier system without an aggressor signal, a power amplifier system with an interference cancellation loop enabled, and a power amplifier system with an interference cancellation loop disabled.

Figure 7 is a graph of aggressor intermodulation relative to a main power amplifier signal power versus power output.

Figure 8 is a schematic diagram of a power amplifier system with interference cancellation applied at a power amplifier input side according to an embodiment.

Figure 9 is a schematic diagram of a power amplifier system with an interference cancellation loop and a non-linearity cancellation loop according to an embodiment.

Figure 10 is a schematic diagram of a power amplifier system with an interference cancellation loop and a non-linearity cancellation path used for digital predistortion according to an embodiment.

DETAILED DESCRIPTION OF CERTAIN EMBODIMENTS

The following detailed description of certain embodiments presents various descriptions of specific embodiments. However, the innovations described herein can be embodied in a multitude of different ways, for example, as defined and covered by the claims. In this description, reference is made to the drawings where like reference numerals can indicate identical or functionally similar elements. It will be understood that elements illustrated in the figures are not necessarily drawn to scale. Moreover, it will be understood that certain embodiments can include more elements than illustrated in a drawing and/or a subset of the illustrated elements. Further, some embodiments can incorporate any suitable combination of features from two or more drawings.

Power amplifiers are significant components of wireless transmitters. Power amplifiers can have a significant contribution to overall system efficiency, linearity, and/or output power. A power amplifier can drive an individual antenna of an antenna array in certain applications.

High efficiency power amplifiers, such as Doherty power amplifiers, out phasing power amplifiers, or segmented power amplifiers, are desirable for a variety of applications. Such power amplifiers can be more non-linear than some other power amplifiers. Digital predistortion (DPD) can be utilized to linearize such power amplifiers.

Modern communication systems can employ multiple antennas for spatial diversity and/or spatial multiplexing mode. The multiple antennas can be included in an antenna array for beamforming and/or for multiple-input multiple-output (MIMO) communications. In such antenna arrays, antennas can support independent streams concurrently. The independent steams can be over the same or different frequencies. Due to limited antenna isolations in certain applications, neighboring streams can modulate the output of power amplifier. This modulation can cause error vector magnitude (EVM) degradation and/or out-of-band (OOB) emissions. Imperfect matching can alternatively or additionally lead to reflections that causes the nonlinearity of the power amplifier to degrade.

In some systems, using an isolator at the power amplifier output can reduce or eliminate coupling between neighboring streams. This can also contribute to desirable power amplifier impedance matching. In such applications, the DPD can compensate for power amplifier nonlinearities at a fixed load.

With the move to higher frequencies and/or massive MIMO systems, arrays with a larger number of antennas are desired. As frequencies increase, antenna dimensions can decrease and there can be challenges with placing isolators. Using isolators in these systems with a relatively large number of antennas can considerably increase the cost and can be impractical due to the limited antenna separation and the bulky nature of the isolators.

This disclosure provides new architectures to cancel interference from undesired coupling with one or more neighboring streams at the power amplifier output. In addition, reflected signals from the antenna can be canceled before modulating the PA output. Architectures disclosed herein can relax the DPD specification to achieve a desired system linearity without using isolators at each power amplifier output. Systems disclosed herein can provide a relatively low cost and compact solution to reduce and/or eliminate neighboring streams linearity degradation of power amplifiers without using isolators at each power amplifier output.

In spatial multiplexing, independent streams can be concurrently transmitted over different antennas sharing the same frequency to increase spectral efficiency. Isolation between antennas that transmit different streams can be limited due to limited distance between adjacent antennas. For instance, adjacent antennas can be spaced apart by distance of $\lambda/2$, where $\lambda$ is a wavelength of a transmitted signal.

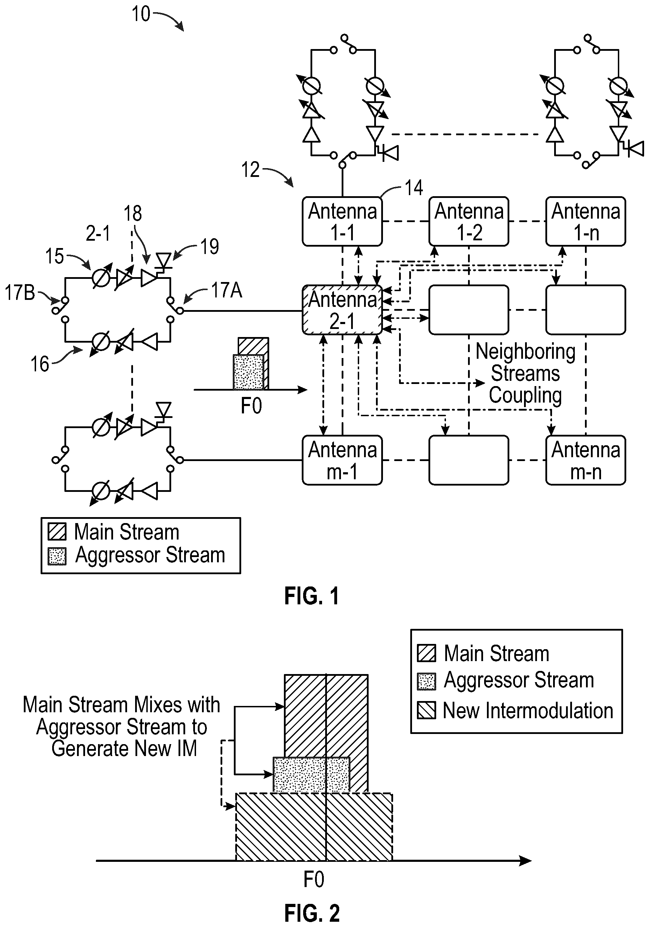

Figure 1 is a schematic diagram of a radio frequency system 10 with an antenna array 12 according to an embodiment. The antenna array 12 includes an array of antennas 14. Each antenna 14 can be referred to as an antenna element. The antenna array 12 can be a phased antenna array. The antenna array 12 can include a relatively large number of antennas 14. For example, the antenna array 12 can include over 1000 antennas in some applications. In some such applications, the antenna array 12 can include between 1000 and 3000 antennas 14. The antenna array 12 can be for sixth generation (6G) technology applications.

The radio frequency system 10 includes a plurality of processing channels each associated with a respective antenna 14. The processing channels can each include a transmit path 15 and a receive path 16. Switches 17A and 17B can selectively electrically couple the transmit path 15 or the receive path 16 to an antenna 14 and a transceiver (not shown in Figure 1). Each transmit path 15 includes a power amplifier 18. The power amplifier 18 can include any suitable power amplifier transistor(s), such as, but not limited to, field effect transistors (FETs) (e.g., metal oxide semiconductor FETs (MOSFETs), p type FETs (PFETs), n type FETs (NFETs), or pseudomorphic high electron mobility transistors (pHEMTs)) or bipolar transistors. The radio frequency system 10 can use the antennas 14 to perform beam scanning, for example.

The antennas 14 are driven by the power amplifiers 18 in the transmit paths 15. Power detection circuitry 19 for a transmit path can detect an indication of reflected power propagating from an antenna 14 to a power amplifier 18, for example. The power detection circuitry 19 can include a radio frequency coupler and a power detector.

Referring to Figure 1, limited isolation between antennas 14 can introduce coupling between neighboring streams and crosstalk to each other. For example, antenna processing stream 2-1 driving antenna 14 at position 2-1 in the antenna array 12 can be subject to coupling with one or more neighboring streams from one or more adjacent antennas 14. In some instances, streams associated with eight neighboring antennas 14 can couple to a single antenna 14.

One or more adjacent neighboring streams coupling can mix and modulate a power amplifier output. This can produce one or more new intermodulation components that can degrade linearity (e.g., EVM and/or adjacent channel power (ACP)) of desired power amplifier output stream. Figure 2 is a graph illustrating a new intermodulation generated by mixing between a main stream and an aggressor stream.

To linearize an output of a power amplifier with the intermodulation shown in Figure 2, DPD can be performed using feedback associated with a main stream, aggressor stream(s), and introduced non-linearities (e.g., IMs) from aggressor stream modulation with the main stream. DPD for power amplifiers driving a full antenna array 12 of Figure 1 could take into account all streams and all generated intermodulations to linearize the power amplifiers. Such DPD would be complex and could be impractical.

Reducing coupling between independent streams can be achieved using miniaturized isolators using semiconductor processes. However, such isolators can have relatively high loss that reduces power amplifier efficiency and/or relatively low linearity.

Some other approaches to reducing coupling between antennas involves combining multiple antennas (e.g., 3 antennas) and driving the combined antennas with a single power amplifier. This can allow for more space to place isolators and/or circulators but can reduce element beamwidth. Such an approach can provide relatively limited beam scanning angles and/or a relatively large array area. In contrast, technical solutions disclosed herein can provide relatively wide beam scanning angles and relatively high isolation.

Aspects of this disclosure relate to power amplifier systems with interference cancellation. Such systems can generate an indication of interfering power and apply a cancellation signal in a signal path that includes a power amplifier. These systems can be implemented without an isolator in a signal path between an output of a power amplifier and an antenna. A power amplifier system can include an array of antennas, a power amplifier in a transmit signal path configured to drive a first antenna of the array, a radio frequency coupler configured to generate an interfering power signal, and an interference cancellation loop configured to receive the interfering power signal and to provide a cancellation signal to the transmit signal path to suppress interference at an output of the power amplifier. The output of the power amplifier can be a drain of a field effect transistor, for example. The interfering power signal can be associated with aggressor power and/or reflected power. The interfering power signal can be representative of power propagating in a direction from the antenna to the output of the power amplifier. The interference cancellation loop can include an amplifier and a phase shifter to generate the cancellation signal from the interfering power signal. The cancellation signal can be applied at an output side of the power amplifier. In some other applications, the cancellation signal can be applied at an input side of the power amplifier.

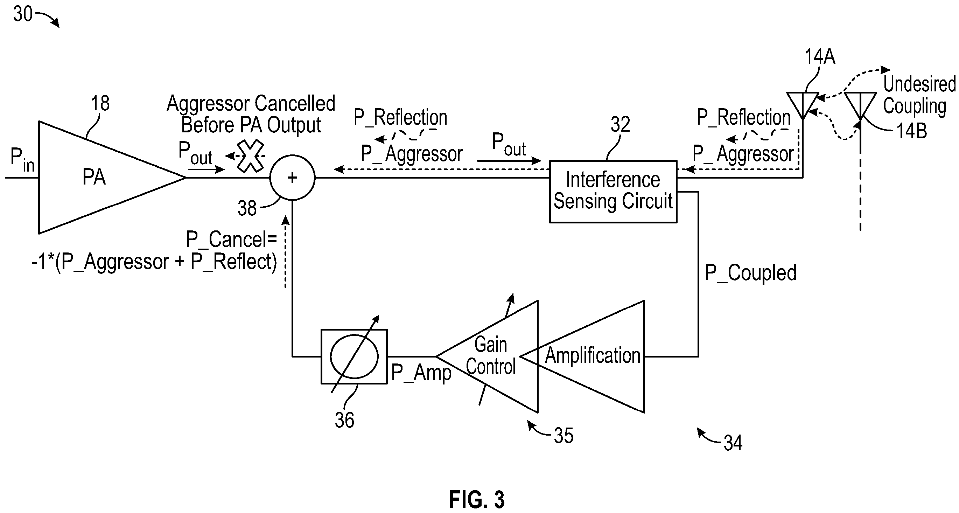

Embodiments of power amplifier systems with interference cancellation will be discussed with reference to Figures 3 to 10. Any suitable principles and advantages of these systems can be implemented together with each other and/or with the radio frequency system 10 of Figure 1. Any suitable principles and advantages of the power amplifier systems of Figures 3 to 10 can be implemented at a power amplifier output that interface with other circuits to cancel a reflected signal and improve power amplifier performance across VSWR variations. The power amplifier systems discussed with reference to Figures 3 to 10 can be implemented for each processing channel driving an antenna array. A radio frequency system with a relatively large antenna array can include a relatively large number of power amplifiers and associated interference cancellation circuitry. The power amplifier systems discussed with reference to Figures 3 to 10 can be implemented in systems that can cancel the a reflected power amplifier signal due to an impedance mismatch and reduce this power amplifier sensitivity in the presence of any load impedance mismatch.

Figure 3 is a schematic diagram of a power amplifier system 30 with interference cancellation according to an embodiment. In the power amplifier system 30, a power amplifier 18 drives a first antenna 14A. There can be undesired coupling between the first antenna 14A and a second antenna 14B that is adjacent to the first antenna 14A. An aggressor signal associated with this undesired coupling can be introduced to a signal path between the power amplifier 18 and the first antenna 14A. There can be an undesired reflected signal generated due to impedance mismatches between the impedance of the power amplifier 18 and the impedance of the first antenna 14A. Interference cancellation in the power amplifier system 30 can reduce and/or eliminate the aggressor signal and/or the reflected signal at the output of a power amplifier 18. Accordingly, intermodulation components associated with the aggressor mixing with an output signal generated by the power amplifier 18 can be suppressed. Alternatively or additionally, the reflected signal generated due to load impedance mismatch can be suppressed, which can reduce the power amplifier sensitivity to VSWR and antenna impedance variations.

The power amplifier system 30 includes an interference sensing circuit 32 in the signal path between the power amplifier 18 and the first antenna 14A. The interference sensing circuit 32 can include a radio frequency directional coupler. The interference sensing circuit 32 can sense interfering power. The interfering power can include power associated with the aggressor signal and/or reflected power associated with an impedance mismatch between the power amplifier output and impedance of the first antenna 14A. Part of the interfering power can be coupled to an interference cancellation loop 34. The interference sensing circuit 32 can be arranged to couple a portion of power propagating in a direction from the first antenna 14A to the power amplifier 18. This coupled power can be referred to as an interfering power signal.

The coupled power P_coupled provided by the interference sensing circuit 32 can be represented by Equation 1:

$$P\_coupled = C * (P\_aggressor + P\_reflected) \qquad \text{(Equation 1)}$$

In Equation 1, C represents a coupling factor, P_aggressor represents undesired aggressor signal power, and P_reflected represents reflected output power due to impedance mismatches. The coupling factor C can be the fraction of the interfering power provided to the interference cancellation loop 34. A higher coupling factor C can introduce more loss in the signal path between the power amplifier 18 and the antenna 14A. With a smaller coupling factor C, there can be more amplification in the interference cancellation loop. The coupled power P_coupled can be in a range from 15 decibels (dB) to 20 dB below the interfering power, for example.

The interference cancellation loop 34 is a feedback loop. The interference cancellation loop 34 includes a controllable amplification circuit 35 and a phase shifter 36 to generate a cancellation signal having an amplitude and a phase to cancel interference at the power amplifier output.

The controllable amplification circuit 35 can amplify power and voltage of the coupled power signal from the interference sensing circuit 32. This can generate an amplitude of the cancellation signal to suppress interference at the power amplifier output. The controllable amplification circuit 35 can have a controllable gain that can be controlled with any suitable analog or digital gain control technique.

The phase shifter 36 can control the phase of the cancellation signal to provide a 180 degree phase shift between the aggressor signal at the power amplifier output and the cancellation signal provided by the interference cancellation loop 34. In some instances, an interference cancellation loop can be implemented without a phase shifter.

The power P_cancel of the cancellation signal can be represented by Equation 2:

$$P\_cancel = -1 * G * L * C * (P\_aggressor + P\_reflected) \qquad \text{(Equation 2)}$$

In Equation 2, G represents the amplification factor for the controllable amplification circuit 35, L represents losses of the phase shifter 36, C represents the coupling factor, P_aggressor represents undesired aggressor signal power, and P_reflected represents reflected output power due to impedance mismatches. For G = 1 / (L * C), Equation 2 can be simplified as Equation 3:

$$P\_cancel = -1 * (P\_aggressor + P\_reflected) \qquad \text{(Equation 3)}$$

The cancellation signal can reduce and/or eliminating interference. The cancellation signal can have approximately the same magnitude and approximately a 180 degree phase shift relative to the interference. The cancellation signal can be in a range from 150 degrees to 210 degrees phase shifted relative to the interference. The cancellation signal can have a similar magnitude to the interference, such as within 20%, within 10%, or within 5%.

The cancellation signal with power P_cancel can be applied to a combiner 38. The combiner 38 can be any suitable combiner, such a node combiner, a Wilkinson combiner, coupler, transformer combiner, or the like. The combiner 38 can be coupled between the output of the power amplifier 18 and the interference sensing circuit 32. The combiner 38 can sum the interference with the cancellation signal from the interference cancellation loop 34 to suppress the interference before interfacing with the non-linear power amplifier load. Accordingly, interference, including aggressor signals and/or reflected power from antenna impedance mismatch, can be cancelled in the power amplifier system 30.

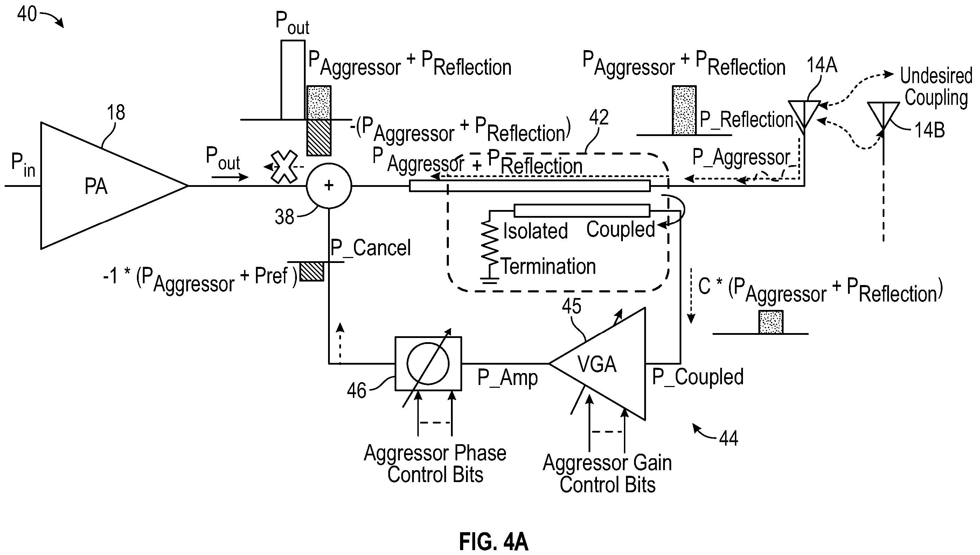

Figure 4A is a schematic diagram of a power amplifier system 40 according to an embodiment. The power amplifier system 40 is an example of the power amplifier system 30 of Figure 3. The power amplifier system 40 includes example circuits for the interference sensing circuit 32, the controllable amplification circuit 35, and the phase shifter 36 of Figure 3.

As illustrated in Figure 4A, the interference sensing circuit 32 of Figure 3 is implemented with a directional coupler 42 with a termination impedance connected to its isolated port and a coupled port providing an indication of power propagating in a direction from the first antenna 14A to the output of the power amplifier 18.

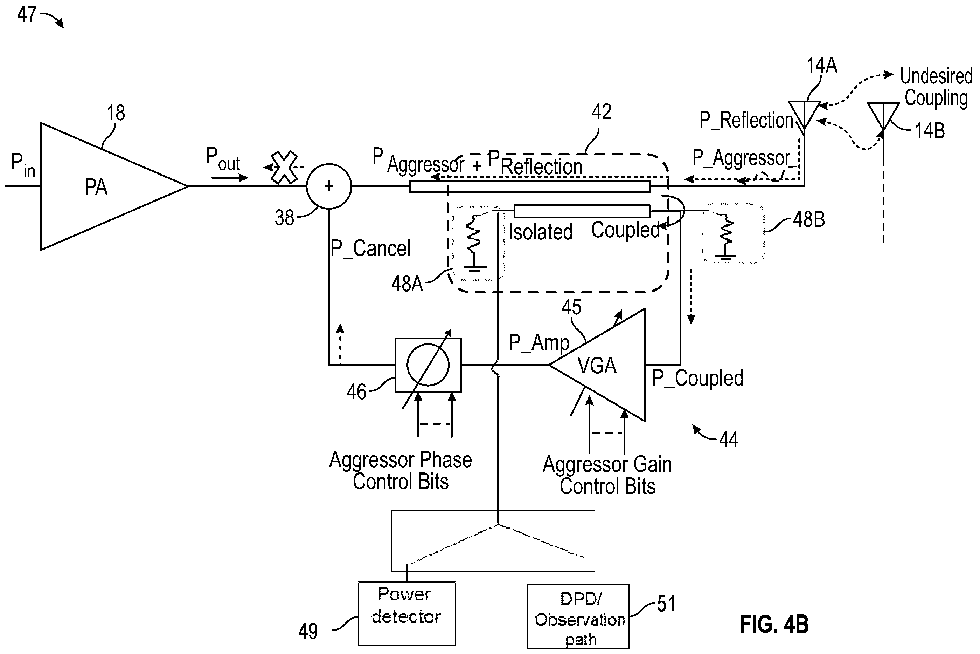

Figure 4B is a schematic diagram of a power amplifier system 47 with a configurable directional coupler 42 according to an embodiment. In certain applications, the directional coupler 42 can be configurable for coupling a portion of power of a radio frequency signal generated by the power amplifier 18 that propagates to the first antenna 14A. The directional coupler 42 of Figure 4B is configurable into a first state to couple interfering power and configurable into a second state to couple forward power.

In the first state, the directional coupler 42 can operate as illustrated in and described with reference to Figure 4A. A switchable termination impedance 48A can be connected to the port of the directional coupler 42 labeled Isolated in Figure 4B and a switchable termination impedance 48B can be disconnected from the port of the directional coupler 42 labeled Coupled in Figure 4B to operate in the first state.

Forward power can be coupled by swapping which ports of the directional coupler 42 are terminated and provide coupled power relative to the connections shown in Figure 4A. For instance, the switchable termination impedance 48B and/or another termination impedance can be connected to the port of the directional coupler 42 labeled Coupled in Figure 4B and the switchable termination impedance 48A can be disconnected from the port of the directional coupler 42 labeled Isolated in Figure 4B to operate in the second state. In such a configuration, a portion of forward power can be coupled to the port of the directional coupler 42 labeled Isolated in Figure 4B. One or more switches and/or other suitable circuitry can configure the directional coupler 42 to couple forward power or reflected power. The coupled forward power from the directional coupler 42 can be provided to a power detector 49 and/or a DPD path 51 in the second state.

Referring to Figure 4A, the power amplifier system 40 includes an interference cancellation loop 44 that includes a variable gain amplifier 45 and a phase shifter 46 that can each be controlled by one or more digital control bits. The variable gain amplifier 45 is an example of the controllable amplification circuit 35 of Figure 3. A gain of the variable gain amplifier 45 can be controlled by one or more digital control bits as illustrated in Figure 4A. In some other applications, the gain of the variable gain amplifier 45 can be controlled by an analog signal, such as an analog control voltage. The controllable amplification circuit 35 of Figure 3 can alternatively be implemented by an amplifier and a variable attenuation circuit.

The phase shifter 46 is an example of the phase shifter 36 of Figure 3. The phase shifter 46 can provide a phase shift based on one or more phase control bits. For instance, a phase control word that includes a plurality of phase control bits can control the phase shift of the phase shifter 46. The phase shifter 46 can include active or/and passive components. The desired phase shift can be controlled with digital control bits or with an analog signal, such as an analog control voltage.

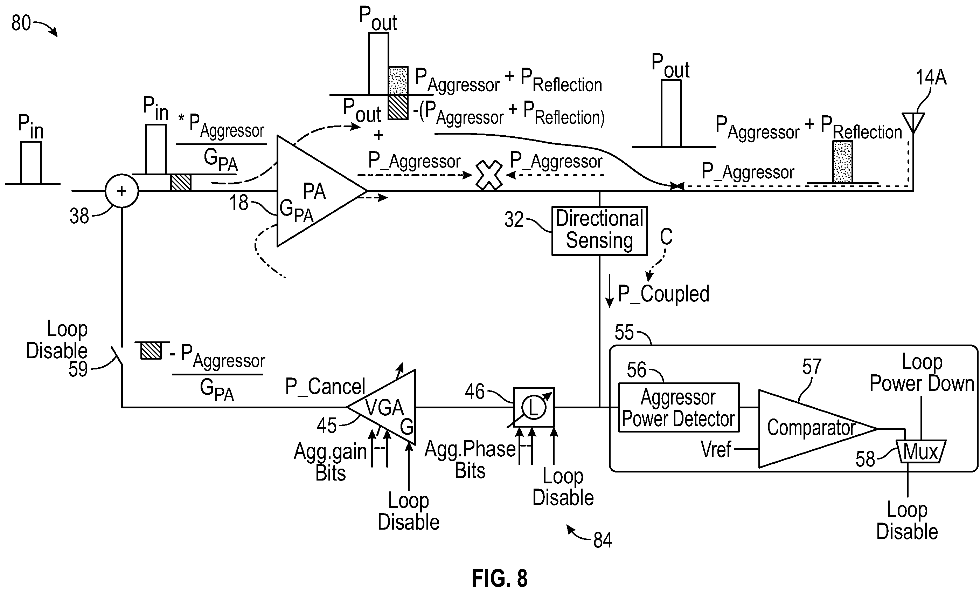

Embodiments of interference cancellation loops for interference cancellation disclosed herein can include an amplifier and a phase shifter. Amplification and phase shifting can be performed in any suitable order. For example, a coupled power signal can be amplified by the amplifier and then phase shifted by the phase shifter in certain systems, such as in the systems of Figure 3-5. As another example, a coupled power signal can be phase shifted by the phase shifter and then amplified by the amplifier in certain systems, such as the systems of Figure 8-10.

Referring to Figure 4A, the combiner 38 can be implemented by a node combiner, a Wilkinson combiner, a directional coupler, transformer combiner, or any other suitable voltage or power combining circuit.

The interference cancellation loop 44 can be implemented with DPD to improve the overall linearity of the power amplifier system 40. In such applications, DPD can linearize the power amplifier 18 and the interference cancellation loop 44 can be tuned to suppress interfering power and associated intermodulation non-linearity. The interference cancellation loop 44 can be tuned by setting control bits for the variable gain amplifier 45 and the phase shifter 46.

Interference cancellation circuity of the power amplifier systems 30 and 40 can improve in-band and out-of-band linearity by suppressing inference, such as an aggressor signal, before the power amplifier load. However, such interference suppression can degrade the overall power amplifier efficiency due to extra power consumption and/or extra loading for the inference sensing and the combiner for applying the cancellation signal.

For low interference levels (e.g., low aggressor power levels), where the generated intermodulation between the power amplifier output and the interference is lower than a threshold, the interference cancellation loop for suppressing interference can be disabled to reduce power consumption and improve power amplifier efficiency. Interference cancellation loops can be selectively disabled and/or enabled for a single processing channel, a subset of processing channels driving antenna elements of an antenna array, or for all processing channels driving antenna elements of an antenna array.

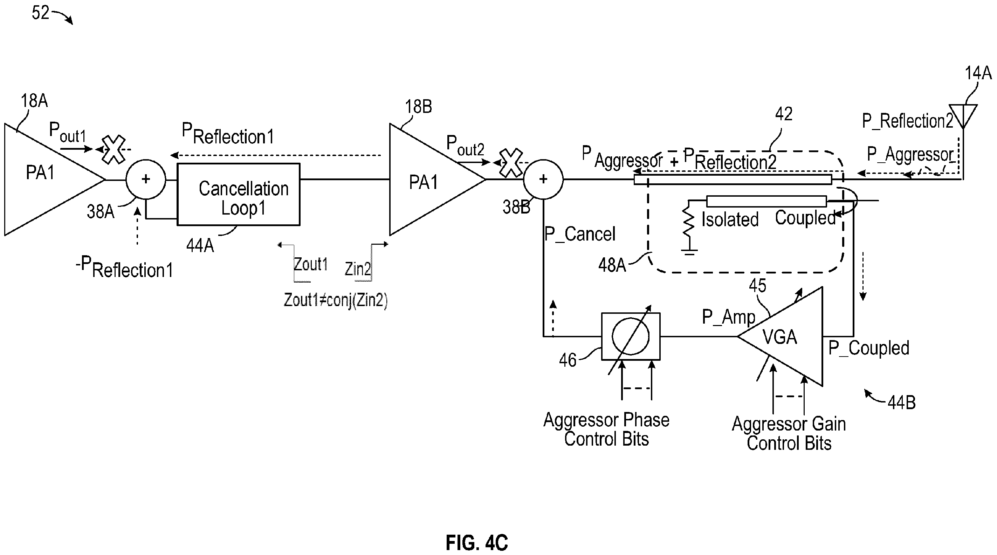

Figure 4C is a schematic diagram of a power amplifier system 52 with interference cancellation for multiple power amplifier stages according to an embodiment. Figure 4C illustrates that an interference cancellation loop can be applied where there may not little or no aggressor interference and/or other interference associated with antennas. For example, an interference cancellation loop in accordance with any suitable principles and advantages disclosed herein can be used, for example, between power amplifier stages of a multistage power amplifier or at a voltage-controlled oscillator and/or phased lock loop driver. In some applications, an interference cancellation loop can cancel reflected power only. The interference cancellation disclosed herein can be applied to suppressing interference associated with any suitable power amplifier load. Such cancellation can advantageously make the power amplifier VSWR insensitive.

Referring to Figure 4C, the power amplifier system 52 includes a first power amplifier stage 18A that drives a second power amplifier stage 18B. When there is a load impedance mismatch for the first power amplifier stage 18A, a first interference cancellation loop 44A can provide cancellation to cancel reflected power PReflection1 associated with the impedance mismatch. This can cancel interference associated with only reflected power in certain instances. The first interference cancellation loop 44A can be implemented in accordance with any suitable principles and advantages of the interference cancellation loop 44 of Figure 4 and/or any other suitable interference cancellation loop disclosed herein. The cancellation signal can be applied at a first combiner 38A.

The second power amplifier stage 18B can then amplify a radio frequency signal where interference is suppressed. A second interference cancellation loop 44B can function as described with reference to Figure 4A and apply a cancellation signal at the second combiner 38B. Accordingly, the power amplifier system 47 can apply cancellation at outputs of separate power amplifier stages.

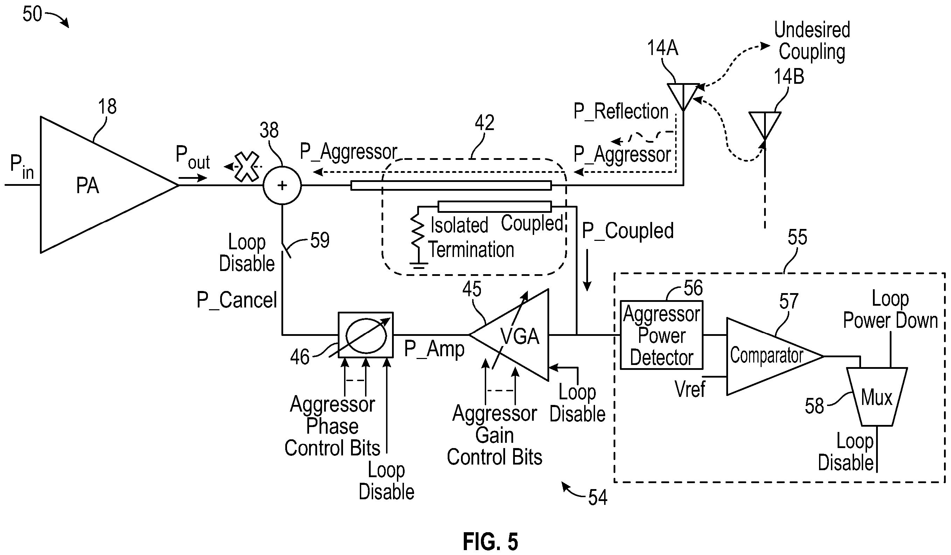

Figure 5 is a schematic diagram of a power amplifier system 50 with interference power monitoring and interference cancellation according to an embodiment. The power amplifier system 50 includes an interference cancellation loop 54 and an interference power monitoring circuit 55. The interference power monitoring circuit 55 can monitor an aggressor power level and selectively disable and/or enable the interference cancellation loop 54. The interference power monitoring circuit 55 can include a power detector 56, a comparator 57, and a multiplexer 58. The power detector 56 can be any suitable power detector or envelope detector. The comparator 57 can compare an output signal from the detector 56 with a reference signal, such as a reference voltage.

The output signal from the detector 56 being higher than the reference signal can indicate that aggressor power is sufficiently high to affect linearity and/or otherwise negatively impact performance. If the output signal from the detector 56 has a greater magnitude than the reference signal, the interference cancellation loop 54 can be enabled. On the other hand, if the output signal from the detector 56 has a lower magnitude than the reference signal, the interference cancellation loop 54 can be disabled. In this case, aggressor power can be relatively low and generate relatively low intermodulation. The descriptions with reference to Figure 5 for monitoring aggressor power can be applicable to monitoring any other suitable interfering power or any other suitable interfering power combined with aggressor power.

The multiplexer 57 can receive an output signal from the comparator 56 and a loop power down signal. The multiplexer 57 can provide a loop disable signal to the interference cancellation loop 54 to disable the interference cancellation loop 54 in response to the output signal from the comparator 56 and/or the loop power down signal.

In the interference cancellation loop 54, the variable gain amplifier 45 and a switch 59 receive the loop disable signal. The loop disable signal can disable the interference cancellation loop 54 by (1) powering down or otherwise deactivating the variable gain amplifier 45 and (2) decoupling the interference cancellation loop from an input to the combiner 38. Any other suitable circuitry can alternatively or additionally disable an interference cancellation loop for suppressing interference. In some instances, the loop disable signal can be provided to one or more interference cancellation loops associated with one or more transmit signals paths that drive a different antenna that is included in the same antenna array as the antenna 14 shown in Figure 5.

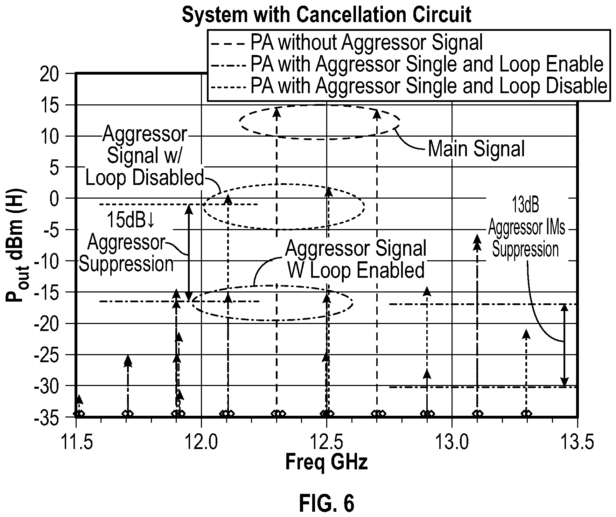

Figure 6 is a graph showing output power over frequency for a power amplifier system without an aggressor signal, a power amplifier system with an interference cancellation loop enabled, and a power amplifier system with an interference cancellation loop disabled. The simulation results in Figure 6 are for a power amplifier with 2 tones in the presence of aggressor coupling and without aggressor coupling.

Comparing the simulation results from the power amplifier system without the aggressor signal and the power amplifier system with the loop disabled, the aggressor tones can be 11 dBc lower than the main power amplifier tones. These aggressor tones can mix with the power amplifier tone and generate intermodulations (IMs) that are 30 dB lower than the main power amplifier tones. With such aggressor tones and IMs with the loop disabled, traditional DPD may not be able to improve the linearity to achieve desired performance specifications, such as achieving 3% EVM, due to the aggressor generated inter-modulation distortion.

Comparing the simulation results from the power amplifier system with the loop disabled and the power amplifier system with the loop enabled, the interference cancellation loop suppressed the 2 aggressor tones by about 15 dB and also suppressed the aggressor generated intermodulation tones by about 13 dB. With such suppression with the interference cancellation loop enabled, the aggressor generated IMs are about 40 dB lower than the main power amplifier tones. With such suppression and DPD for linearizing the power amplifier, EVM of less than 3% can be achieved due to suppressed aggressor generated IMs.

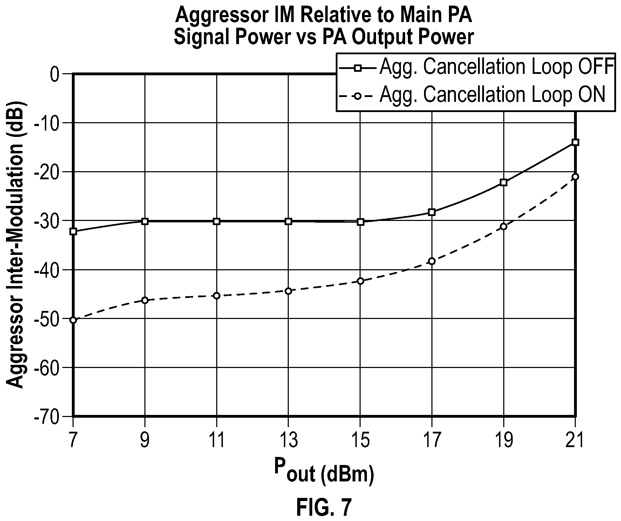

Figure 7 is a graph of aggressor intermodulation relative to a main power amplifier signal power versus power output. The aggressor intermodulation can be produced due mixing between a main power amplifier signal with a coupled aggressor signal. The aggressor intermodulation is shown in Figure 7 versus the main power amplifier signal output power. These IM results were generated with aggressor power lower than the main power amplifier power by 11 dB.

With the interference cancellation loop disabled, the IM associated with the aggressor signal is around 30 dBc relative to the main power amplifier input power even at lower power amplifier output power. This aggressor IM level can cause EVM degradation and OOB emissions. With the interference cancellation loop enabled, this IM (1) reduced by about 18 dB at low output power to achieve aggressor IM of less than 50 dBc and (2) was suppressed by about 13 dB to achieve aggressor of less than 40 dBc for higher power amplifier output power up to around 16 dBm. This improved IM of less than 40 dBc should improve the linearity of transmitted signal (e.g., EVM, ACP) and reduce the OOB emissions. Figure 7 indicates that the cancellation level is lower at power amplifier output power of greater than 15dB. This can be due to higher power amplifier non-linearity and operation near saturation power.

In certain instances, interference cancellation can be applied at an input of a power amplifier. This can utilize the gain of the power amplifier in amplifying the cancellation signal to provide interference suppression at a power amplifier output. Example power amplifier systems with interference suppression at an input side of a power amplifier will be discussed with reference to Figures 8 to 10. In some other instances, interference cancellation can be applied at an intermediate stage of a power amplifier between an input stage and an output stage. In such instances, an interference cancellation loop can provide a cancellation signal between stages of a power amplifier such that interference is suppressed at an output of the power amplifier.

Figure 8 is a schematic diagram of a power amplifier system 80 with interference cancellation applied at a power amplifier input side according to an embodiment. The power amplifier system 80 includes an interference cancellation loop 84 that provides a cancellation signal to a combiner 38. The combiner 38 combines the power amplifier input signal with the cancellation signal. This combined signal is provided to an input of the power amplifier 18 and amplified by the power amplifier 18. This can use the amplification of the power amplifier 18 in amplifying the cancellation signal to cancel interference at the power amplifier output.

In the power amplifier system 80, the power amplifier output power Pout can be represented by Equation 4:

$$ \text{P\_out} = G_{\text{PA}} * (\text{P\_in} + \text{P\_cancel}) \qquad \text{(Equation 4)} $$

In Equation 4, $G_{\text{PA}}$ represents the gain of the power amplifier 18, P_in is the power of the power amplifier input signal, and P_cancel is the power of the cancellation signal. The power of the cancellation signal P_cancel can be computed based on Equation 2. For $G_{\text{PA}} * G * L * C = 1$, Equation 4 can be simplified to Equation 5:

$$ \text{P\_out} = G_{\text{PA}} * \text{P\_in} - \text{P\_interference} \qquad \text{(Equation 5)} $$

In Equation 4, $G_{\text{PA}} * \text{P\_in}$ represents the power of the amplified power amplifier input signal and P_interference represents the interference signal power at the power amplifier output including power from an undesired aggressor signal power and power from impedance mismatches.

By using the power amplifier 18 to amplify the cancellation signal from the interference cancellation loop 84, the variable gain amplifier 45 of the interference cancellation loop 84 can have a lower gain than amplifiers of interference cancellation loops that apply cancellation at an output side of a power amplifier. For example, using the power amplifier 18 to amplify the cancellation signal in the power amplifier system 80 can reduce power consumption of the interference cancellation loop 84 compared to the interference cancellation loop 34 of Figure 3, the interference cancellation loop 44 of Figure 4A, and the interference cancellation loop 54 of Figure 5. This can improve overall efficiency of the power amplifier system 80.

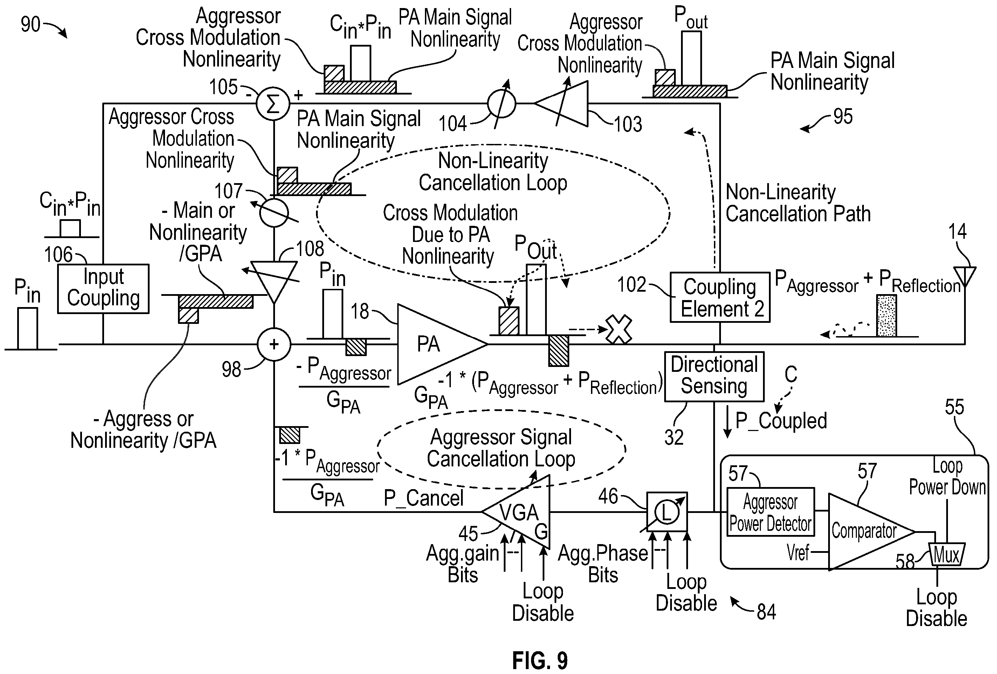

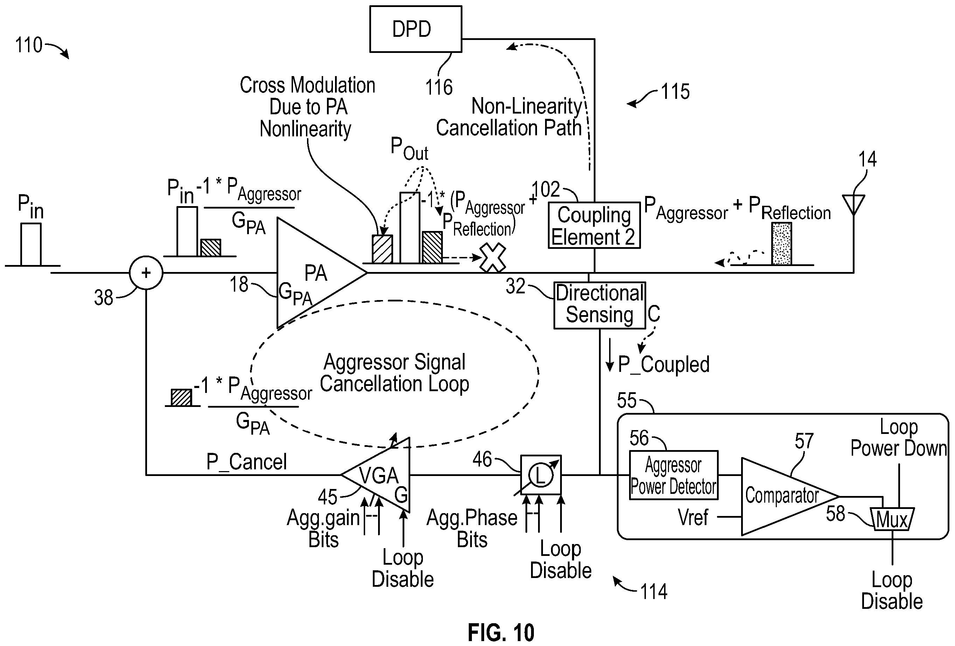

The power amplifier 18 can have non-linearities. Amplifying the cancellation signal from an interference cancellation loop with the power amplifier 18 can introduce non-linearities in the output signal provided by the power amplifier 18. Figures 9 and 10 provide technical solutions to suppress such non-linearities associated with amplifying a cancellation signal.

Figure 9 is a schematic diagram of a power amplifier system 90 with an interference cancellation loop 84 and a non-linearity cancellation loop 95 according to an embodiment. To suppress non-linearities associated with amplifying the cancellation signal from the interference cancellation loop 84 with the power amplifier, the non-linearity cancellation loop 95 can cancel the combined nonlinearity at the output of the power amplifier 18. The interference cancellation loop 84 can cancel the interference at the output of the power amplifier 18.

The output signal provided by the power amplifier 18 can have a cross modulation associated with the power amplifier input signal and the cancellation signal due to non-linearity of the power amplifier 18. The non-linearity cancellation loop 95 can cancel the combined non-linear intermodulation components from the main power amplifier input signal non-linearity and intermodulation due to the mixing the power amplifier main input and the cancellation signal.

A second coupling element 102 can couple a portion of power amplifier output power that includes non-linearity components to provide a second coupled signal to the non-linearity cancellation loop 95. The second coupling element 102 can be a radio frequency coupler. The second coupled power signal can be a portion of forward power propagating from the power amplifier 18 to the antenna 14. The second coupled power signal can be amplified and phase shifted. For example, the second coupled power signal can be provided to a variable gain control circuit 103 to adjust its amplitude and then phase shifted by a variable delay circuit 104 to compensate and/or control the phase of the second coupled signal. A modified coupled power signal is generated by amplifying and phase shifting the second coupled power signal.

The modified signal is applied to a signal combining circuit 105 that subtracts a linear power amplifier signal from the modified signal. An input coupling circuit 106 can provide a coupled power signal of the power amplifier input signal having an amplitude that can cancel the linear component of the modified signal. Accordingly, the output of the signal combining circuit 105 is left with only the non-linearity components of the power amplifier output signal. The output signal from the signal combining circuit 105 can be phase shifted and amplified to control the amplitude and phase for combining with the power amplifier input signal. A controllable phase shifter 107 can perform such phase shifting, and a controllable gain amplifier 108 can perform such amplification.

A combiner 98 can combine the power amplifier input signal, the cancellation signal, and a non-linearity cancellation signal such that (1) interference is cancelled at the output of the power amplifier 18 and (2) non-linearities are cancelled at the output of the power amplifier 18.

Figure 10 is a schematic diagram of a power amplifier system 110 with an interference cancellation loop 114 and a non-linearity cancellation path 115 for digital predistortion according to an embodiment. The non-linearity cancellation path 115 can suppress non-linearities associated with amplifying the cancellation signal generated by the interference cancellation loop 114 using the power amplifier 18. The interference cancellation loop 114 can cancel the interference at the power amplifier output.

The second coupling element 102 can couple a portion of power amplifier output power including non-linearity components to provide an observation signal to the non-linearity cancellation path 115. The observation signal can represent forward power propagating from the power amplifier 18 to the antenna 14. The observation signal can be provided to a DPD circuit 116. In some instances, one or more circuit elements (not illustrated) can be in a signal path between the second coupling element 102 and the DPD circuit 116. The DPD circuit 116 can adjust the input signal to the power amplifier 18 based on the observation signal. This can reduce the overall non-linearity at the output of the power amplifier 18.

In the power amplifier system 110, the interference cancellation loop 114 can cancel interference associated with an undesired large aggressor signal that is challenging to cancel with DPD only and DPD can be used to cancel all non-linearity components at the output of the power amplifier 18.

Technical solutions for suppressing interference are provided. An interfering power signal can be generated that represents an aggressor signal and/or a reflected power signal propagating from the antenna to the output of a power amplifier. A radio frequency coupler, such as a directional coupler, can generate the interfering power signal . The interfering power signal can be amplified and phase shifted to generate a cancellation signal. The cancellation signal can be applied in a transmit signal path that includes the power amplifier. The cancellation signal can be applied to a combiner at an output side of a power amplifier, between stages of a power amplifier, or at an input side of a power amplifier. In some embodiments, an interference power detection circuit can detect a power level associated with interference and selectively activate and/or deactivate the interference cancellation loop based on the detected power level associated with interference.

In the embodiments described above, systems, apparatus, circuits, and methods for suppressing interference at an output of a power amplifier are described in connection with particular embodiments. It will be understood, however, that the principles and advantages of the embodiments can be used for any other systems, apparatus, or methods with a need for suppressing interference at a power amplifier output.

The principles and advantages described herein can be implemented in various apparatuses. Examples of such apparatuses can include, but are not limited to, communications infrastructure such as wireless communications infrastructure, consumer electronic products, parts of the consumer electronic products, electronic test equipment, vehicular electronic products, industrial electronic products, etc. Electronic products can include, but are not limited to, base stations such as cellular base stations, access points, repeaters, relays, wireless communication devices, a mobile phone (for example, a smart phone), a hand-held computer, a tablet computer, a laptop computer, a wearable computing device, a vehicular electronics system, a radio, a wearable health monitoring device, etc. Further, apparatuses can include unfinished products.

Unless the context clearly requires otherwise, throughout the description and the claims, the words "comprise," "comprising," "include," "including," and the like are to be construed in an inclusive sense, as opposed to an exclusive or exhaustive sense; that is to say, in the sense of "including, but not limited to." The words "coupled" or connected", as generally used herein, refer to two or more elements that may be either directly connected, or connected by way of one or more intermediate elements. Additionally, the words "herein," "above," "below," and words of similar import, when used in this application, shall refer to this application as a whole and not to any particular portions of this application. Where the context permits, words in the Detailed Description using the singular or plural number may also include the plural or singular number, respectively. The words "or" in reference to a list of two or more items, is intended to cover all of the following interpretations of the word: any of the items in the list, all of the items in the list, and any combination of the items in the list. All numerical values provided herein are intended to include similar values within a measurement error.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states.

The teachings of the inventions provided herein can be applied to other systems, not necessarily the systems described above. The elements and acts of the various embodiments described above can be combined to provide further embodiments. The acts of the methods discussed herein can be performed in any order as appropriate. Moreover, the acts of the methods discussed herein can be performed serially or in parallel, as appropriate.

While certain embodiments of the inventions have been described, these embodiments have been presented by way of example only, and are not intended to limit the scope of the disclosure. Indeed, the novel methods and systems described herein may be embodied in a variety of other forms. Furthermore, various omissions, substitutions and changes in the form of the methods and systems described herein may be made without departing from the spirit of the disclosure.

The accompanying claims and their equivalents are intended to cover such forms or modifications as would fall within the scope and spirit of the disclosure. Accordingly, the scope of the present inventions is defined by reference to the claims.

There follows a list of numbered features defining particular embodiments of the present disclosure. Where a numbered feature refers to one or more earlier numbered features then those features should be considered together in combination with each other.

1. A power amplifier system with interference cancellation, the power amplifier system comprising:

an array of antennas comprising a first antenna and a second antenna;
a transmit signal path comprising a power amplifier, the power amplifier configured to drive the first antenna;
a radio frequency coupler in a signal path between the power amplifier and the first antenna, the radio frequency coupler configured to generate an interfering power signal; and
an interference cancellation loop comprising an amplifier and a phase shifter, the interference cancellation loop configured to receive the interfering power signal and to provide a cancellation signal to the transmit signal path to suppress interference at an output of the power amplifier, and the interference comprising an aggressor signal associated with the second antenna.

2. The power amplifier system of feature 1, further comprising an interfering power monitoring circuit configured to enable the interference cancellation loop based on a power level of the interfering power signal.

3. The power amplifier system of feature 1 or 2, wherein the interference cancellation loop is configured to apply the cancellation signal at an output side of the power amplifier.

4. A power amplifier system with interference cancellation, the power amplifier system comprising:

a transmit signal path comprising a power amplifier;
an interference sensing circuit connected to an output of the power amplifier, the interference sensing circuit configured to output an interfering power signal; and
an interference cancellation loop comprising an amplifier, the interference cancellation loop configured to receive the interfering power signal and to provide a cancellation signal to the transmit signal path to thereby suppress interference at the output of the power amplifier.

5. The power amplifier system of feature 4, wherein the interference cancellation loop further comprises a phase shifter, the interference cancellation loop configured to generate the cancellation signal by at least amplifying and phase shifting the interfering power signal using the amplifier and the phase shifter.

6. The power amplifier system of feature 4 or 5, wherein the interference cancellation loop has a controllable gain, and the interference cancellation loop is configured to set the controllable gain to control an amplitude of the cancellation signal.

7. The power amplifier system of any of features 4 to 6, wherein the interference sensing circuit comprises a radio frequency coupler.

8. The power amplifier system of any of features 4 to 7, wherein the radio frequency coupler is configurable into a first state and a second state, the radio frequency coupler is configured to couple interfering power in the first state, and the radio frequency coupler is configured to couple forward power in the second state.

9. The power amplifier system of any of features 4 to 8, further comprising an antenna array, the antenna array comprising a first antenna that is connected to the power amplifier by way of the interference sensing circuit.

10. The power amplifier system of feature 9, wherein the interference comprises interference associated with coupling of a second antenna of the antenna array and the first antenna.

11. The power amplifier system of any of features 4 to 10, wherein the interference comprises reflected power associated with an impedance mismatch at the output of the power amplifier.

12. The power amplifier system of any of features 4 to 11, further comprising an interfering power monitoring circuit configured to enable the interference cancellation loop based on a power level of the interfering power signal.

13. The power amplifier system of any of features 4 to 12, wherein the interference cancellation loop is configured to apply the cancellation signal to at an output side of the power amplifier.

14. The power amplifier system of any of features 4 to 13, wherein the interference cancellation loop is configured to apply the cancellation signal to an input side of the power amplifier.

15. The power amplifier system of feature 14, further comprising a second non-linearity cancellation loop configured to provide a non-linearity cancellation signal at the input side of the power amplifier.

16. The power amplifier system of feature 14 or 15, further comprising a radio frequency coupler and a digital predistortion circuit, the radio frequency coupler configured to provide a coupled power signal to the digital predistortion circuit, and the digital predistortion circuit configured to reduce non-linearity at the output of the power amplifier, wherein the coupled power signal is associated with power propagating from the output of the power amplifier to an antenna.

17. A method of interference cancellation in a power amplifier system, the method comprising:

sensing interference in a signal path between a power amplifier and a first antenna, the interference propagating in a direction toward an output of the power amplifier, the interference comprising an aggressor signal associated with a second antenna;
generating a cancellation signal based on the sensing; and
applying the cancellation signal to a transmit signal path that includes the power amplifier to suppress the interference at the output of the power amplifier.

18. The method of feature 17, wherein the sensing comprises generating a coupled power signal using a radio frequency coupler, and wherein the generating the cancellation signal comprises amplifying and phase shifting the coupled power signal.

19. The method of feature 17 or 18, wherein the sensing comprises generating a coupled power signal using a radio frequency coupler, and the method further comprises enabling circuitry that performs the generating based on a power level of the coupled power signal.

20. The method of any of features 17 to 19, wherein the applying comprises applying the cancellation signal at an output side of the power amplifier.

**Claims**

1. A power amplifier system with interference cancellation, the power amplifier system comprising:

   i. a transmit signal path comprising a power amplifier;
   ii. an interference sensing circuit connected to an output of the power amplifier, the interference sensing circuit configured to output an interfering power signal; and
   iii. an interference cancellation loop comprising an amplifier, the interference cancellation loop configured to receive the interfering power signal and to provide a cancellation signal to the transmit signal path to thereby suppress interference at the output of the power amplifier.

2. The power amplifier system of Claim 1, wherein the interference cancellation loop further comprises a phase shifter, the interference cancellation loop configured to generate the cancellation signal by at least amplifying and phase shifting the interfering power signal using the amplifier and the phase shifter.

3. The power amplifier system of any of Claims 1 or 2, wherein the interference cancellation loop has a controllable gain, and the interference cancellation loop is configured to set the controllable gain to control an amplitude of the cancellation signal.

4. The power amplifier system of any of Claims 1 to 3, wherein the interference sensing circuit comprises a radio frequency coupler; wherein optionally: the radio frequency coupler is configurable into a first state and a second state, the radio frequency coupler is configured to couple interfering power in the first state, and the radio frequency coupler is configured to couple forward power in the second state.

5. The power amplifier system of any of Claims 1 to 4, further comprising an antenna array, the antenna array comprising a first antenna that is connected to the power amplifier by way of the interference sensing circuit; wherein optionally the interference comprises interference associated with coupling of a second antenna of the antenna array and the first antenna.

6. The power amplifier system of any of Claims 1 to 5, wherein the interference comprises reflected power associated with an impedance mismatch at the output of the power amplifier.

7. The power amplifier system of any of Claims 1 to 6, further comprising an interfering power monitoring circuit configured to enable the interference cancellation loop based on a power level of the interfering power signal.

8. The power amplifier system of any of Claims 1 to 7, wherein the interference cancellation loop is configured to apply the cancellation signal to one or both of:

   a. a) an output side of the power amplifier; and/or
   b. b) an input side of the power amplifier.

9. The power amplifier system of Claim 8, further comprising a second non-linearity cancellation loop configured to provide a non-linearity cancellation signal at the input side of the power amplifier.

10. The power amplifier system of Claim 8 or 9, further comprising a radio frequency coupler and a digital predistortion circuit, the radio frequency coupler configured to provide a coupled power signal to the digital predistortion circuit, and the digital predistortion circuit configured to reduce non-linearity at the output of the power amplifier, wherein the coupled power signal is associated with power propagating from the output of the power amplifier to an antenna.

11. A method of interference cancellation in a power amplifier system, the method comprising:

   i. sensing interference in a signal path between a power amplifier and a first antenna, the interference propagating in a direction toward an output of the power amplifier, the interference comprising an aggressor signal associated with a second antenna;
   ii. generating a cancellation signal based on the sensing; and
   iii. applying the cancellation signal to a transmit signal path that includes the power amplifier to suppress the interference at the output of the power amplifier.

12. The method of Claim 11, wherein the sensing comprises generating a coupled power signal using a radio frequency coupler, the method further comprising one or both of:

   i) the generating the cancellation signal comprises amplifying and phase shifting the coupled power signal; and/or
   ii) enabling circuitry that performs the generating based on a power level of the coupled power signal.

13. The method of Claims 11 or 12, wherein the applying comprises applying the cancellation signal at an output side of the power amplifier.

14. A power amplifier system with interference cancellation, the power amplifier system comprising:

   i. an array of antennas comprising a first antenna and a second antenna;
   ii. a transmit signal path comprising a power amplifier, the power amplifier configured to drive the first antenna;
   iii. a radio frequency coupler in a signal path between the power amplifier and the first antenna, the radio frequency coupler configured to generate an interfering power signal; and
   iv. an interference cancellation loop comprising an amplifier and a phase shifter, the interference cancellation loop configured to receive the interfering power signal and to provide a cancellation signal to the transmit signal path to suppress interference at an output of the power amplifier, and the interference comprising an aggressor signal associated with the second antenna.

15. The power amplifier system of Claim 14, wherein one or both of the following apply:

a. the power amplifier system further comprises an interfering power monitoring circuit configured to enable the interference cancellation loop based on a power level of the interfering power signal; and/or

b. the interference cancellation loop is configured to apply the cancellation signal at an output side of the power amplifier.

**FIG. 1**

Main Stream
Aggressor Stream

Main Stream Mixes with
Aggressor Stream to
Generate New IM

Main Stream
Aggressor Stream
New Intermodulation

F0

**FIG. 2**

FIG. 3

EP 4 580 092 A1

FIG. 4A

Undesired Coupling

14B

14A

$P_{Aggressor} + P_{Reflection}$

$P\_Reflection$

$P\_Aggressor$

$C * (P_{Aggressor} + P_{Reflection})$

$P\_Coupled$

44

Aggressor Gain Control Bits

VGA

45

Isolated Coupled

Termination

42

$-(P_{Aggressor} + P_{Reflection})$

$P_{Aggressor} + P_{Reflection}$

$P\_Amp$

Aggressor Phase Control Bits

46

$P_{Aggressor} + P_{Reflection}$

$P_{out}$

$P_{Aggressor} + P_{Reflection}$

$P\_Cancel$

38

$-1 * (P_{Aggressor} + Pref)$

$P_{out}$

18

PA

$P_{in}$

40

$-1 * (P_{Aggressor} + P_{Reflection})$

FIG. 4B

EP 4 580 092 A1

FIG. 4C

**FIG. 5**

EP 4 580 092 A1

FIG. 6

**Aggressor IM Relative to Main PA Signal Power vs PA Output Power**

FIG. 7

**FIG. 8**

EP 4 580 092 A1

FIG. 9

EP 4 580 092 A1

FIG. 10

Europäisches
Patentamt

European
Patent Office

Office européen
des brevets

# EUROPEAN SEARCH REPORT

**Application Number**

EP 24 22 1176

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/267956 A1 (GRANGER-JONES MARCUS [US] ET AL) 29 August 2019 (2019-08-29) * paragraph [0006] - paragraph [0008] * * paragraph [0030] * * paragraph [0037] - paragraph [0044] * * figure 1 * | 1-15 | INV. H04B17/13 H04B17/16 H04B17/19 |
| X | US 2005/174173 A1 (BLODGETT JAMES R [US]) 11 August 2005 (2005-08-11) * paragraph [0019] - paragraph [0028] * * figure 1 * | 1-15 | |

TECHNICAL FIELDS
SEARCHED     (IPC)

H04B

The present search report has been drawn up for all claims

| Place of search | Date of completion of the search | Examiner |
|---|---|---|
| The Hague | 9 May 2025 | Sklavos, Alexandros |

EPO FORM 1503 03.82 (P04C01)

## ANNEX TO THE EUROPEAN SEARCH REPORT
## ON EUROPEAN PATENT APPLICATION NO.

EP 24 22 1176

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | Publication date | Patent family member(s) | Publication date |
|---|---|---|---|
| US 2019267956 A1 | 29-08-2019 | US 2019267956 A1 | 29-08-2019 |
| | | US 2020067468 A1 | 27-02-2020 |
| US 2005174173 A1 | 11-08-2005 | AU 2003247621 A1 | 06-01-2004 |
| | | CA 2527628 A1 | 31-12-2003 |
| | | CN 1663116 A | 31-08-2005 |
| | | EP 1552605 A2 | 13-07-2005 |
| | | JP 2005531224 A | 13-10-2005 |
| | | MX PA05000247 A | 11-04-2005 |
| | | US 2005174173 A1 | 11-08-2005 |
| | | WO 2004001956 A2 | 31-12-2003 |

EPO FORM P0459

For more details about this annex : see Official Journal of the European Patent Office, No. 12/82